# EUROPEAN PATENT APPLICATION

(11) **EP 4 806 695 A1**
(43) Date of publication of application: **16.09.2026**
(21) Application number: 24888954.5
(22) Date of filing: 14.10.2024
(51) Int. Cl.: B60K 35/00, G02B 27/01, H04N 9/31, B60K 35/23, B60K 35/28, G06F 3/147, B60K 35/10, B60K 35/22, B60K 35/60, B60K 35/80, B60K 35/81, B60K 37/20, G09G 5/10

(54) **DISPLAY DEVICE FOR VEHICLE**

(30) Priority: 08.11.2023 KR 20230153775
(71) Applicant: LG Electronics Inc., Yeongdeungpo-gu Seoul 07336 (KR)
(72) Inventor: CHOI, Joongho, Seoul 06772 (KR); HWANG, Jooyong, Seoul 06772 (KR); KIM, Kyunglack, Seoul 06772 (KR); JUNG, Youngho, Seoul 06772 (KR); KIM, Doyoung, Seoul 06772 (KR); KIM, Jinyong, Seoul 06772 (KR); PANG, Seokjin, Seoul 06772 (KR); KWAK, Youngshin, Ulju-gun Ulsan 44919 (KR); PARK, Hyunhee, Ulju-gun Ulsan 44919 (KR)
(74) Representative: Vossius & Partner Patentanwälte Rechtsanwälte mbB
(86) International application number: PCT/KR2024/015497
(87) International publication number: WO 2025/100760

(57) **Abstract**

A display apparatus for a vehicle is disclosed. A display apparatus for a vehicle according to an embodiment of the present disclosure includes: an illuminance sensor configured to sense external illuminance information of the vehicle; an image output device configured to output an image; and a signal processing device configured to output an output image signal to the image output device based on an input image signal, wherein the signal processing device is configured to: extract luminance data and chroma data from the input image signal; calculate a compensation value for the luminance data and a compensation value for the chroma data based on the external illuminance information of the vehicle; and output an output image signal based on the calculated compensation value for the luminance data and the calculated compensation value for the chroma data. Accordingly, it is possible to prevent degradation of visibility based on ambient light.

## Description

### BACKGROUND

### 1. Field

The present disclosure relates to a display apparatus for a vehicle, and more particularly, to a display apparatus for a vehicle capable of preventing degradation of visibility based on ambient light.

### 2. Description of the Related Art

A vehicle is a machine that allows a user who rides therein to move in a desired direction. A representative example of the vehicle is a car.

Meanwhile, for convenience of vehicle users, some vehicles are equipped with a display apparatus or device.

For example, a display is positioned on an instrument cluster to present various types of information. In addition to the cluster display, in order to display vehicle driving information and the like, various displays, such as a center information display (CID) and a head-up display that outputs a projection image onto a windshield, are increasingly being mounted in vehicles.

Meanwhile, there is a problem in that visibility of an image displayed on a head-up display or the like is degraded due to external light outside a vehicle.

### SUMMARY

It is an object of the present disclosure to provide a display apparatus for a vehicle capable of preventing degradation of visibility based on ambient light.

It is another object of the present disclosure to provide a display apparatus for a vehicle capable of reducing degradation in perception of luminance and chroma based on ambient light.

In accordance with an aspect of the present disclosure, the above and other objects can be accomplished by providing a display apparatus for a vehicle including: an illuminance sensor configured to sense external illuminance information of the vehicle; an image output device configured to output an image; and a signal processing device configured to output an output image signal to the image output device based on an input image signal, wherein the signal processing device is configured to: extract luminance data and chroma data from the input image signal; calculate a compensation value for the luminance data and a compensation value for the chroma data based on the external illuminance information of the vehicle; and output an output image signal based on the calculated compensation value for the luminance data and the calculated compensation value for the chroma data.

The signal processing device can be configured to: calculate the compensation value for the luminance data based on an average value of the luminance data of the input image signal; and calculate the compensation value for the chroma data based on a standard deviation of the chroma data of the input image signal.

The signal processing device can be configured to increase the compensation value for the luminance data and the compensation value for the chroma data as a level of the external illuminance information of the vehicle increases.

While calculating the compensation value for the luminance data based on the external illuminance information of the vehicle, the signal processing device can be configured to: in response to a first luminance level of the input image signal being less than a reference luminance level, increase the first luminance level by a first luminance increment; and in response to a second luminance level of the input image signal being greater than the reference luminance level, increase the second luminance level by a second luminance increment less than the first luminance increment.

While calculating the compensation value for the chroma data based on the external illuminance information of the vehicle, the signal processing device can be configured to: in response to a first chroma level of the input image signal being less than a reference chroma level, increase the first chroma level by a first chroma increment; and in response to a second chroma level of the input image signal being greater than the reference chroma level, increase the second chroma level by a second chroma increment less than the first chroma increment.

The signal processing device can be configured to: output a first image including text in a normal mode; and output a second image including an object or an image in a compensation mode based on the external luminance information of the vehicle.

In response to switching from a normal mode to a compensation mode, the signal processing device can be configured to switch an output from a first image including text to a second image including an object or an image in addition to the text.

The image output device can include a picture generation device configured to output a projection image toward a windshield.

The image output device can include a display including an organic light emitting diode panel.

The image output device can include a display including a transparent organic light emitting diode panel. A transparency of the transparent organic light emitting diode panel can be lower than a transparency of a windshield.

In accordance with another aspect of the present disclosure, there is provided a display apparatus for a vehicle including: an illuminance sensor configured to sense external illuminance information of the vehicle; an image output device configured to output an image; and a signal processing device configured to output an output image signal to the image output device based on an input image signal, wherein the signal processing device is configured to: output a first image in a normal mode; and output a second image having an increased luminance level and an increased chroma level than the first image in a compensation mode based on the external illuminance information of the vehicle.

The signal processing device can be configured to: output the first image including text in the normal mode; and output a second image including an object or an image in the compensation mode based on the external illuminance information of the vehicle.

In response to switching from the normal mode to the compensation mode, the signal processing device can be configured to switch an output from the first image including text to the second image including an object or an image in addition to the text.

The image output device can include a picture generation device configured to output a projection image toward a windshield.

The image output device can include a display including an organic light emitting diode panel.

### EFFECTS OF THE DISCLOSURE

A display apparatus for a vehicle according to an embodiment of the present discourse includes: an illuminance sensor configured to sense external illuminance information of the vehicle; an image output device configured to output an image; and a signal processing device configured to output an output image signal to the image output device based on an input image signal, wherein the signal processing device is configured to: extract luminance data and chroma data from the input image signal; calculate a compensation value for the luminance data and a compensation value for the chroma data based on the external illuminance information of the vehicle; and output an output image signal based on the calculated compensation value for the luminance data and the calculated compensation value for the chroma data. Accordingly, it is possible to prevent degradation of visibility based on ambient light. In particular, it is possible to reduce degradation in perception of luminance and chroma based on ambient light.

The signal processing device can be configured to: calculate the compensation value for the luminance data based on an average value of the luminance data of the input image signal; and calculate the compensation value for the chroma data based on a standard deviation of the chroma data of the input image signal. Accordingly, it is possible to prevent degradation of visibility based on ambient light.

The signal processing device can be configured to increase the compensation value for the luminance data and the compensation value for the chroma data as a level of the external illuminance information of the vehicle increases. Accordingly, it is possible to prevent degradation of visibility based on ambient light.

While calculating the compensation value for the luminance data based on the external illuminance information of the vehicle, the signal processing device can be configured to: in response to a first luminance level of the input image signal being less than a reference luminance level, increase the first luminance level by a first luminance increment; and in response to a second luminance level of the input image signal being greater than the reference luminance level, increase the second luminance level by a second luminance increment less than the first luminance increment. Accordingly, it is possible to prevent degradation of visibility based on ambient light.

While calculating the compensation value for the chroma data based on the external illuminance information of the vehicle, the signal processing device can be configured to: in response to a first chroma level of the input image signal being less than a reference chroma level, increase the first chroma level by a first chroma increment; and in response to a second chroma level of the input image signal being greater than the reference chroma level, increase the second chroma level by a second chroma increment less than the first chroma increment. Accordingly, it is possible to prevent degradation of visibility based on ambient light.

The signal processing device can be configured to: output a first image including text in a normal mode; and output a second image including an object or an image in a compensation mode based on the external luminance information of the vehicle. Accordingly, it is possible to prevent degradation of visibility based on ambient light.

In response to switching from a normal mode to a compensation mode, the signal processing device can be configured to switch an output from a first image including text to a second image including an object or an image in addition to the text. Accordingly, it is possible to prevent degradation of visibility based on ambient light.

The image output device can include a picture generation device configured to output a projection image toward a windshield. Accordingly, it is possible to prevent degradation of visibility based on ambient light.

The image output device can include a display including an organic light emitting diode panel. Accordingly, it is possible to prevent degradation of visibility based on ambient light.

The image output device can include a display including a transparent organic light emitting diode panel. A transparency of the transparent organic light emitting diode panel can be lower than a transparency of a windshield. Accordingly, it is possible to prevent degradation of visibility based on ambient light.

A display apparatus for a vehicle according to another embodiment of the present disclosure includes: an illuminance sensor configured to sense external illuminance information of the vehicle; an image output device configured to output an image; and a signal processing device configured to output an output image signal to the image output device based on an input image signal, wherein the signal processing device is configured to: output a first image in a normal mode; and output a second image having an increased luminance level and an increased chroma level than the first image in a compensation mode based on the external illuminance information of the vehicle. Accordingly, it is possible to prevent degradation of visibility based on ambient light. In particular, it is possible to reduce degradation in perception of luminance and chroma based on ambient light.

The signal processing device can be configured to: output the first image including text in the normal mode; and output a second image including an object or an image in the compensation mode based on the external illuminance information of the vehicle. Accordingly, it is possible to prevent degradation of visibility based on ambient light.

In response to switching from the normal mode to the compensation mode, the signal processing device can be configured to switch an output from the first image including text to the second image including an object or an image in addition to the text. Accordingly, it is possible to prevent degradation of visibility based on ambient light.

The image output device can include a picture generation device configured to output a projection image toward a windshield. Accordingly, it is possible to prevent degradation of visibility based on ambient light.

The image output device can include a display including an organic light emitting diode panel. Accordingly, it is possible to prevent degradation of visibility based on ambient light.

### BRIEF DESCRIPTION OF THE DRAWINGS

FIG. 1 illustrates an example of the exterior and interior of a vehicle.
FIG. 2 illustrates an outer appearance of a display apparatus for a vehicle according to an embodiment of the present disclosure.
FIG. 3 illustrates an example of an internal block diagram of the display apparatus for a vehicle of FIG. 2.
FIGS. 4A to 4C are diagrams illustrating various structures of a head-up display of FIG. 3.
FIG. 4D illustrates an example of the operation of the head-up displays of FIGS. 4A to 4C.
FIG. 5 illustrates an example of an internal block diagram of a display apparatus for a vehicle according to an embodiment of the present disclosure.
FIG. 6 is an internal block diagram of a second display of FIG. 3.
FIGS. 7A to 7D are diagrams referred to in the description of an organic light emitting diode panel of FIG. 6.
FIGS. 8A to 8C are diagrams for explaining the operation of a display apparatus for a vehicle related to the present disclosure.
FIG. 9 is a flowchart illustrating a method of operating a display apparatus for a vehicle according to an embodiment of the present disclosure.
FIG. 10 illustrates an example of an internal block diagram of a signal processing device according to an embodiment of the present disclosure.
FIGS. 11A to 12B are diagrams referred to in the description of FIG. 9 or FIG. 10.
FIG. 13 is a flowchart illustrating a method of operating a display apparatus for a vehicle according to another embodiment of the present disclosure.
FIG. 14 is a diagram referred to in the description of FIG. 13.

### DETAILED DESCRIPTION OF THE PREFERRED EMBODIMENTS

Hereinafter, the present disclosure will be described in detail with reference to the accompanying drawings.

With respect to constituent elements used in the following description, suffixes "module" and "unit" are given only in consideration of ease in preparation of the specification, and do not have or serve different meanings. Accordingly, the suffixes "module" and "unit" can be used interchangeably.

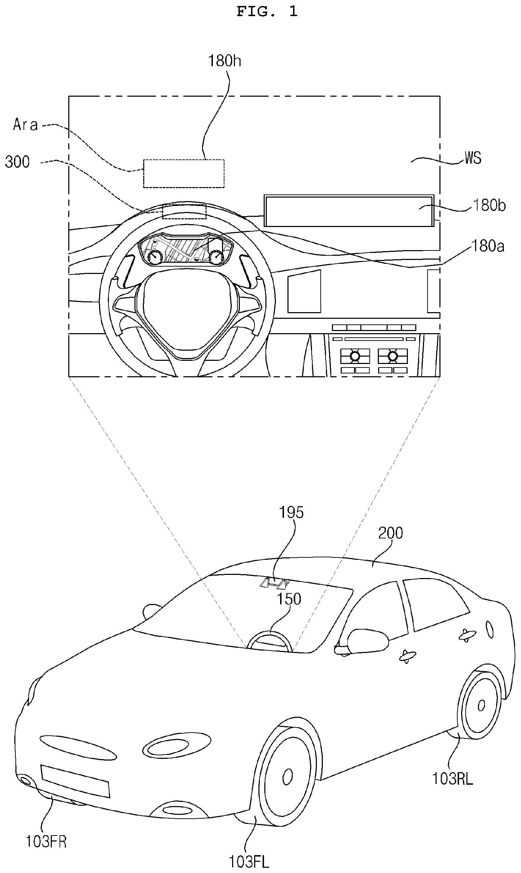

FIG. 1 illustrates an example of the exterior and interior of a vehicle.

Referring to FIG. 1, a vehicle 200 can include a plurality of wheels 103FR, 103FL, 103RL,... rotated by a power source and a steering wheel 150 for adjusting a traveling direction of the vehicle 200.

The vehicle 200 can further include a camera 195 for acquiring an image of the front of the vehicle.

The vehicle 200 can be provided therein with a plurality of displays 180a, 180b, and 180h for displaying images, information, and the like.

For example, among the plurality of displays 180a, 180b, and 180h, a first display 180a can be a cluster display, a second display 180b can be a center information display (CID), and a third display 180h can be a head-up display (HUD) that projects an image onto a predetermined area Ara of a windshield WS.

Meanwhile, the vehicle 200 described herein can be a concept including all of an internal combustion engine vehicle having an engine as a power source, a hybrid vehicle having an engine and an electric motor as power sources, and an electric vehicle having an electric motor as a power source.

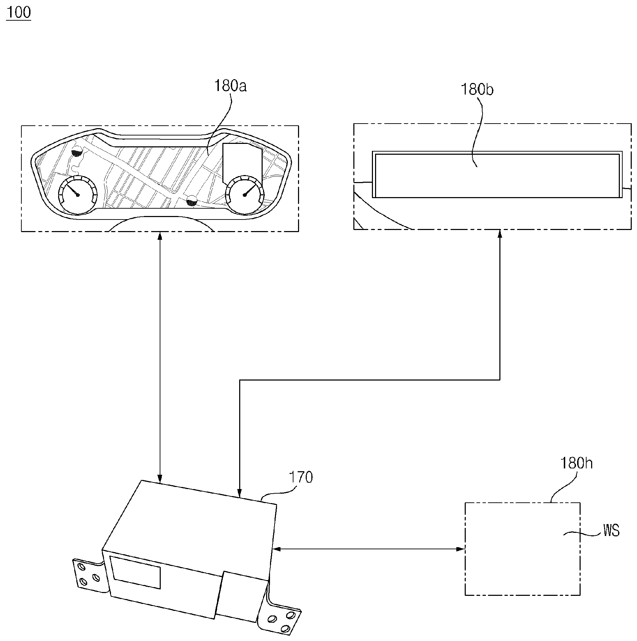

FIG. 2 illustrates an outer appearance of a display apparatus for a vehicle according to an embodiment of the present disclosure.

A display apparatus 100 for a vehicle (or simply "vehicle display apparatus") according to an embodiment of the present disclosure can include a signal processing device 170 configured to perform signal processing to display an image, information, and the like on at least one of the plurality of displays 180a, 180b, and 180h.

The signal processing device 170 can perform signal processing based on an input image signal and output a processed output image signal to at least one of the plurality of displays 180a, 180b, and 180h.

As for the plurality of displays 180a, 180b, and 180h, the first display 180a can be a cluster display 180a for displaying a driving state and operation information, the second display 180b can be a center information display (CID) for displaying vehicle operation information, a navigation map, various types of entertainment information, or an image, and the third display 180h can be a HUD display 180h for displaying vehicle driving information.

The signal processing device 170 can be provided therein with a memory 508 and a processor 175 to control at least one of the plurality of displays 180a, 180b, and 180h.

Meanwhile, the signal processing device 170 can execute first to third virtual machines (not shown) on a hypervisor 505 in the processor 175.

The first virtual machine (not shown), which is a server virtual machine, can control the second virtual machine (not shown) and the third virtual machine (not shown), which are guest virtual machines.

Meanwhile, the second virtual machine can be referred to as a first guest virtual machine, and the third virtual machine can be referred to as a second guest virtual machine.

The first guest virtual machine (not shown) can be operated for the first display 180a, and the second guest virtual machine (not shown) can be operated for the second display 180b or the third display 180h.

Meanwhile, the server virtualization machine (not shown) in the processor 175 can be configured to set the memory 508 based on the hypervisor 505 for transmission of the same data to the first guest virtualization machine (not shown) and the second guest virtualization machine (not shown). Accordingly, the first display 180a and the second display 180b in the vehicle can display the same information or the same image in a synchronized manner.

Meanwhile, the server virtualization machine (not shown) in the processor 175 can receive and process wheel speed sensor data of the vehicle, and can transmit the processed wheel speed sensor data to at least one of the first guest virtualization machine (not shown) and the second guest virtualization machine (not shown). Accordingly, at least one virtual machine can share the wheel speed sensor data of the vehicle.

Thus, by using the single signal processing device 170, it is possible to control the plurality of displays 180a, 180b, and 180h.

Meanwhile, some of the plurality of displays 180a, 180b, and 180h can operate under a Linux-based operating system (OS), and others can operate under a Web-based operating system (OS).

According to an embodiment of the present disclosure, the signal processing device 170 can control the plurality of displays 180a, 180b, and 180h operating under different operating systems (OS) to display the same information or the same image in a synchronized manner.

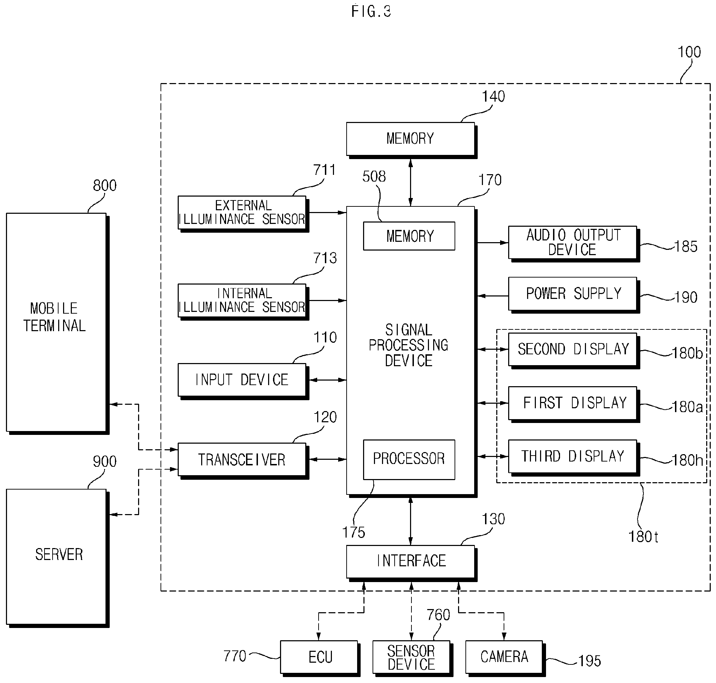

FIG. 3 illustrates an example of an internal block diagram of the display apparatus for a vehicle of FIG. 2.

Referring to FIG. 3, the vehicle display apparatus 100 according to an embodiment of the present disclosure includes an external illuminance sensor 711 configured to sense external illuminance information of a vehicle, an image output device 180t configured to output an image, and a signal processing device 170 configured to output an output image signal to the image output device 180t based on an input image signal.

The vehicle display apparatus 100 according to an embodiment of the present disclosure 100 can further include an input device 110, a transceiver 120, an interface 130, a memory 140, an internal illuminance sensor 713, an audio output device 185, a power supply 190, and the like.

Meanwhile, the image output device 180t can include at least one display 180a, 180b, 180h.

That is, the image output device 180t can include at least one of a cluster display 180a, a CID display 180b, or a head-up display (HUD) 180h.

The input device 110 can include a physical button, a pad, and the like for button input, touch input, and the like.

Meanwhile, the input device 110 can include a microphone (not shown) for user voice input.

The transceiver 120 can wirelessly exchange data with a mobile terminal 800 or a server (not shown).

In particular, the transceiver 120 can wirelessly exchange data with a mobile terminal of a vehicle driver. Any of various data communication schemes, such as Bluetooth, Wi-Fi, Wi-Fi Direct, and APIX, can be used as a wireless data communication scheme.

The transceiver 120 can receive weather information and road traffic condition information, e.g., transport protocol expert group (TPEG) information, from the mobile terminal 800 or the server (not shown). To this end, the transceiver 120 can include a mobile communication module (not shown).

The interface 130 can receive sensor information from an electronic control unit (ECU) 770 or a sensor device 760, and can transmit the received information to the signal processing device 170.

Here, the sensor information can include at least one of vehicle heading information, vehicle location information (global positioning system (GPS) information), vehicle angle information, vehicle speed information, vehicle acceleration information, vehicle tilt information, vehicle forward/backward movement information, battery information, fuel information, tire information, vehicle lamp information, in-vehicle temperature information, and in-vehicle humidity information.

The sensor information can be acquired from a heading sensor, a yaw sensor, a gyro sensor, a position module, a vehicle forward/backward movement sensor, a wheel sensor, a vehicle speed sensor, a vehicle body tilt sensor, a battery sensor, a fuel sensor, a tire sensor, a steering wheel rotation sensor, an in-vehicle temperature sensor, an in-vehicle humidity sensor, etc. The position module can include a GPS module for receiving GPS information.

Meanwhile, the interface 130 can receive front-of-vehicle image data, side-of-vehicle image data, rear-of-vehicle image data, and obstacle-around-vehicle distance information from a camera 195, a LiDAR (not shown), or the like, and can transmit the received information to the signal processing device 170.

The memory 140 can store various data necessary for the overall operation of the vehicle display apparatus 100, such as programs for processing or control of the signal processing device 170.

For example, the memory 140 can store data regarding a hypervisor, a server virtual machine (not shown), and a plurality of guest virtual machines to execute within the processor 175.

The audio output device 185 can convert an electrical signal from the signal processing device 170 into an audio signal and output the audio signal. To this end, the audio output device 185 can include a speaker and the like.

Under the control of the signal processing device 170, the power supply 190 can supply power required for the operation of each component. In particular, the power supply 190 can receive power from a battery in the vehicle.

The HUD display 180h, which is the third display, can include a picture generation device 300 (see FIG. 1) for projecting an image, and can output an augmented reality-based object under the control of the signal processing device 170.

For example, the HUD display 180h can output vehicle speed information, vehicle traveling direction information, a forward-vehicle object, a distance indicator showing a distance to a vehicle ahead, and the like.

In another example, the HUD display 180h can output an augmented reality lane carpet, an augmented reality route carpet, or an augmented reality dynamic carpet corresponding to a road image.

The signal processing device 170 can control the plurality of displays 180a, 180b, and 180h.

The signal processing device 170 can control the overall operation of each unit or device in the vehicle display apparatus 100.

For example, the signal processing device 170 can include a memory 508 and a processor 175 configured to perform signal processing for the vehicle displays 180a and 180b.

The processor 175 can execute the hypervisor (not shown), and can execute the server virtual machine (not shown) and the plurality of guest virtual machines (not shown) on the executed hypervisor.

Here, the first guest virtual machine (not shown) can be operated for the first display 180a, and the second guest virtual machine (not shown) can be operated for the second display 180b or the third display 180h.

Meanwhile, the signal processing device 170 can process various signals, such as an audio signal, a video (or image) signal, and a data signal. To this end, the signal processing device 170 can be implemented in the form of a system on chip (SOC).

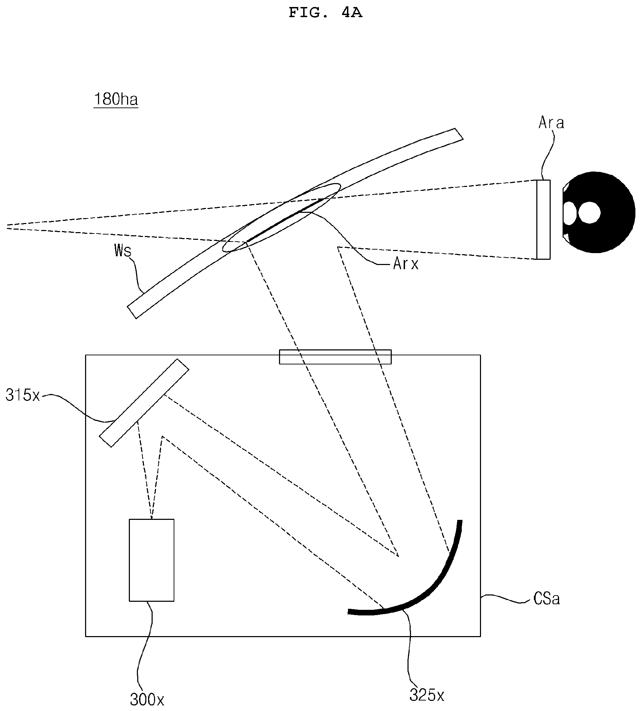

FIGS. 4A to 4C are diagrams illustrating various structures of the head-up display of FIG. 3.

First, FIG. 4A illustrates an example of a head-up display according to an embodiment of the present disclosure.

Referring to FIG. 4A, a head-up display 180ha according to an embodiment of the present disclosure includes a liquid crystal display panel 300x configured to output a projection image, a fold mirror 315x configured to reflect the projection image from the liquid crystal display panel 300x, and a concave mirror 325x configured to reflect the projection image from the fold mirror 315x onto a windshield WS.

The projection image reflected from a predetermined area Arx of the windshield WS is output to a driver's viewing area Ara.

The concave mirror 325x in the head-up display 180ha is disposed between the liquid crystal display panel 300x and the driver's viewing area Ara.

Meanwhile, the concave mirror 325x in the head-up display 180ha determines an arrangement of the projection image and a position of a light source.

For example, by increasing a magnification of the concave mirror 325x in the head-up display 180ha and reducing a focal length, a size CSa of the head-up display 180ha can be reduced.

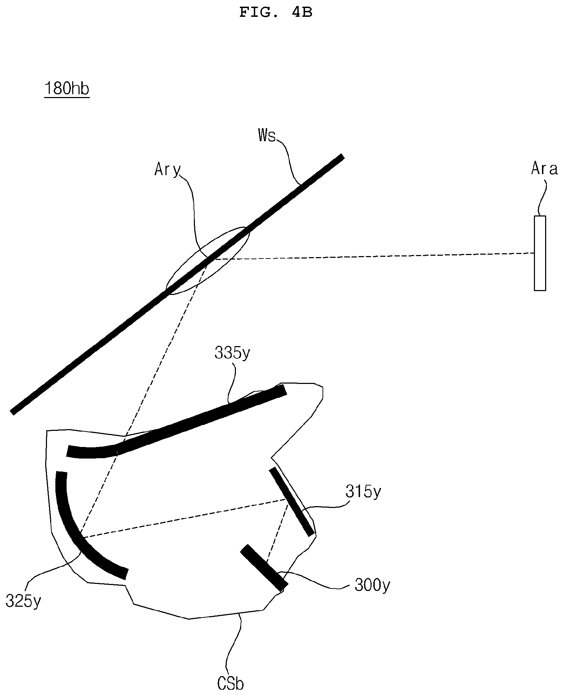

Next, FIG. 4B illustrates another example of a head-up display according to an embodiment of the present disclosure.

Referring to FIG. 4B, a head-up display 180hb according to an embodiment of the present disclosure includes a liquid crystal display panel 300y configured to output a projection image, a fold mirror 315y configured to reflect the projection image from the liquid crystal display panel 300y, a concave mirror 325y configured to reflect the projection image from the fold mirror 315y, and a transparent cover 335y configured to output the projection image from the concave mirror 325y onto a windshield WS.

The projection image reflected from a predetermined area Ary of the windshield WS is output to a driver's viewing area Ara.

Unlike FIG. 4A, the concave mirror 325y in the head-up display 180hb is disposed in front of the liquid crystal display panel 300y and the driver's viewing area Ara.

That is, the liquid crystal display panel 300y in the head-up display 180hb is disposed between the concave mirror 325y and the driver's viewing area Ara.

Meanwhile, the concave mirror 325y in the head-up display 180hb determines an arrangement of the projection image and a position of a light source.

For example, by increasing a magnification of the concave mirror 325y in the head-up display 180hb and reducing a focal length, a size CSb of the head-up display 180hb can be reduced.

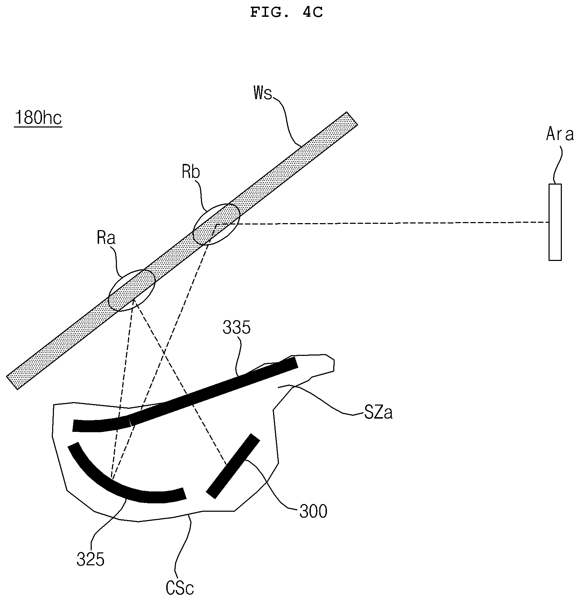

Next, FIG. 4C illustrates yet another example of a head-up display according to an embodiment of the present disclosure.

Referring to FIG. 4C, a head-up display 180hc according to an embodiment of the present disclosure includes a picture generation device 300 configured to output a projection image toward a windshield WS, and a mirror 325 configured to reflect the projection image, reflected from a first area Ra of the windshield WS, toward the windshield WS.

The projection image from the mirror 325 is reflected from a second area Rb of the windshield WS and output to a third area Ara. In this case, the third area Ara can correspond to a driver's viewing area.

Meanwhile, the head-up display 180hc according to an embodiment of the present disclosure uses double reflection at the windshield WS, thereby securing a sufficient optical path while reducing a size thereof.

That is, the head-up display 180hc has a size CSc, which is smaller than the size CSa of the head-up display 180ha of FIG. 4A or the size CSb of the head-up display 180hb of FIG. 4B.

Accordingly, it is possible to reduce the size while implementing a large-screen projection image. In particular, it is possible to reduce the size while securing the optical path.

Meanwhile, the second area Rb of the windshield WS can be closer to the third area Ara than the first area Ra of the windshield WS.

Meanwhile, an incident angle of the projection image incident on the first area Ra of the windshield WS can be greater than an incident angle of the projection image incident on the second area Rb of the windshield WS. Accordingly, it is possible to reduce the size while implementing a large-screen projection image.

Meanwhile, the picture generation device 300 can be closer to the third area Ara than the mirror 325.

Meanwhile, the picture generation device 300 can be disposed at a position higher than that of the mirror 325. Accordingly, it is possible to reduce the size while implementing a large-screen projection image.

Meanwhile, the picture generation device 300 can include a digital mirror device or a liquid crystal display panel, thereby allowing the projection image to be output to the outside of the picture generation device 300.

For example, the picture generation device 300 can include a light source (not shown) and a digital mirror device (not shown) configured to reflect light output from the light source.

The light source can include an LED diode or a laser diode.

Meanwhile, the digital mirror device can include a plurality of digital mirrors. For example, the digital mirror device can include a digital micromirror device (DMD).

In another example, the picture generation device 300 can include a light source (not shown) and a liquid crystal display panel (not shown) configured to output a projection image based on light output from the light source.

The liquid crystal display panel can output a projection image of P-polarized light.

Meanwhile, the first area Ra of the windshield WS can correspond to a black masking area or a frit area FZ of FIG. 1, thereby improving brightness of the projection image.

Meanwhile, the head-up display 180hc according to an embodiment of the present disclosure can further include a transparent cover 335 disposed between the picture generation device 300 and the windshield WS. Accordingly, the projection image can be output to the outside of the picture generation device 300 while protecting the interior of the picture generation device 300.

Meanwhile, in the head-up display 180ha of FIG. 4A, an optical path before a first reflection of a projection image output from the liquid crystal display panel 300x is formed to be shorter than an optical path from after the first reflection to before a second reflection.

In this case, the optical path before the first reflection of the projection image output from the liquid crystal display panel 300x corresponds to a path between the liquid crystal display panel 300x and the fold mirror 315x, and the optical path from after the first reflection to before the second reflection corresponds to a path between the fold mirror 315x and the concave mirror 325x.

In particular, in the head-up display 180ha of FIG. 4A, the optical path before the first reflection of the projection image output from the liquid crystal display panel 300x is significantly shorter than the optical path from after the first reflection to before the second reflection.

Meanwhile, an optical path before a first reflection of a projection image output from the picture generation 300 of FIG. 4C is longer than an optical path from after the first reflection to before a second reflection.

The optical path before the first reflection of the projection image output from the picture generation device 300 in the head-up display 180hc of FIG. 4C corresponds a path between the picture generation device 300 and the first area Ra of the windshield WS.

Meanwhile, the optical path from after the first reflection to before the second reflection in the head-up display 180hc corresponds to a path between the first area Ra of the windshield WS and the mirror 325.

As shown in the drawings, since the optical path before the first reflection of the projection image output from the picture generation device 300 is formed to be longer than the optical path from after the first reflection to before the second reflection, it is possible to secure a sufficient optical path in the head-up display 180hc having a reduced size CSc.

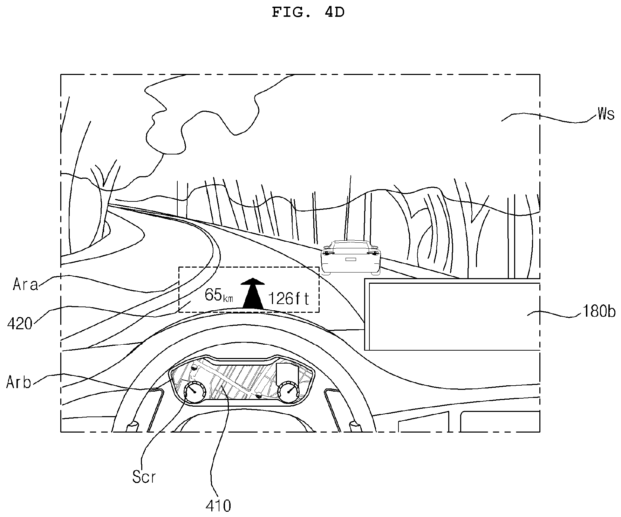

FIG. 4D illustrates an example of the operation of the head-up displays of FIGS. 4A to 4C.

Referring to the figure, FIG. 4D illustrates that a cluster image 410 is displayed on a screen Scr, which is the first display 180a, and a HUD image 420, which is a virtual image, is displayed in a predetermined area Ara in front of a windshield WS.

According to the head-up display 180ha of FIG. 4A, the head-up display 180hb of FIG. 4B, or the head-up display 180hc of FIG. 4C, as shown in FIG. 4D, the cluster image 410 can be displayed on the screen Scr, and the HUD image 420 can be displayed in a predetermined area Ara of the windshield Ws.

Meanwhile, as shown in FIG. 4D, in order to display both an area Ara in which the HUD image is displayed and an area Arb in which the screen Scr is located, the plurality of displays 180a and 180h can be implemented in an integrated manner.

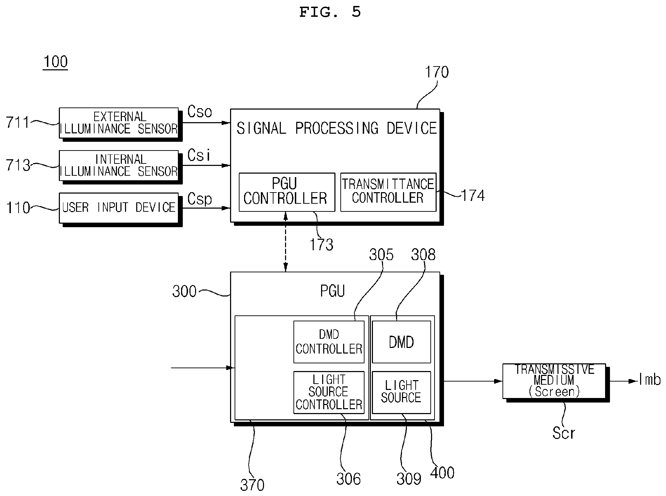

FIG. 5 illustrates an example of an internal block diagram of a display apparatus for a vehicle according to an embodiment of the present disclosure.

Referring to FIG. 5, the vehicle display apparatus 100 according to an embodiment of the present disclosure includes an external illuminance sensor 711 configured to senses external illuminance information of a vehicle, an image output device 180t configured to output an image, and a signal processing device 170 configured to output an output image signal to the image output device 180t based on an input image signal.

Meanwhile, the vehicle display apparatus 100 according to an embodiment of the present disclosure can further include a picture generation device 300, an internal illuminance sensor 713 configured to sense internal illuminance information of the vehicle, and a user input device 110.

Meanwhile, a projection image output from the picture generation device 300 is output to a windshield WS and is projected onto or reflected by the windshield WS, which serves as a reflective medium.

Meanwhile, a projection image LTb reflected from the windshield WS can be displayed as a HUD image Imb in a predetermined area Ara.

Meanwhile, the signal processing device 170 can output a control signal for controlling the picture generation device 300 based on external illuminance Cso from the external illuminance sensor 711, an internal illuminance Csi from the internal illuminance sensor 713, or a setting input Csp from the user input device 110.

For example, the signal processing device 170 can be configured to increase a luminance level and a chroma level of the projection image LTb as the external illuminance Cso increases.

In another example, the signal processing device 170 can be configured to decrease the luminance level and the chroma level of the projection image LTb as the internal illuminance Csi decreases.

In another example, the signal processing device 170 can be configured to decrease the luminance level and the chroma level of the projection image LTb as the setting input Csp decreases.

Accordingly, it is possible to prevent degradation of visibility of the projection image LTb reflected on the windshield WS.

Meanwhile, the signal processing device 170 can be configured to increase the luminance level and the chroma level of the projection image LTb as a difference between external illuminance of the vehicle 200 and internal illuminance of the vehicle 200 increases. Accordingly, it is possible to prevent degradation of visibility of the projection image LTb.

Meanwhile, the picture generation device 300 includes a light output device 400 for light output.

The light output device 400 can include a light source 309 and a digital mirror device 308 that reflects light output from the light source 309.

For example, the light source 309 can include an LED diode, a laser diode, or the like.

Meanwhile, the digital mirror device 308 can include a plurality of digital mirrors. For example, the digital mirror device 308 can include a digital micromirror device (DMD).

Meanwhile, the picture generation device 300 can further include a digital mirror controller 305 for controlling the digital mirror device 308, and a light source controller 306 for controlling the light source 309.

In particular, the picture generation device 300 can be provided with a processor 370, and the processor 370 can include the digital mirror controller 305 for controlling the digital mirror device 308 and the light source controller 306 for controlling the light source 309.

Meanwhile, the signal processing device 170 can include a picture generation controller 173 for controlling the picture generation device 300.

The picture generation controller 173 can be provided in the processor 175 of the signal processing device 170.

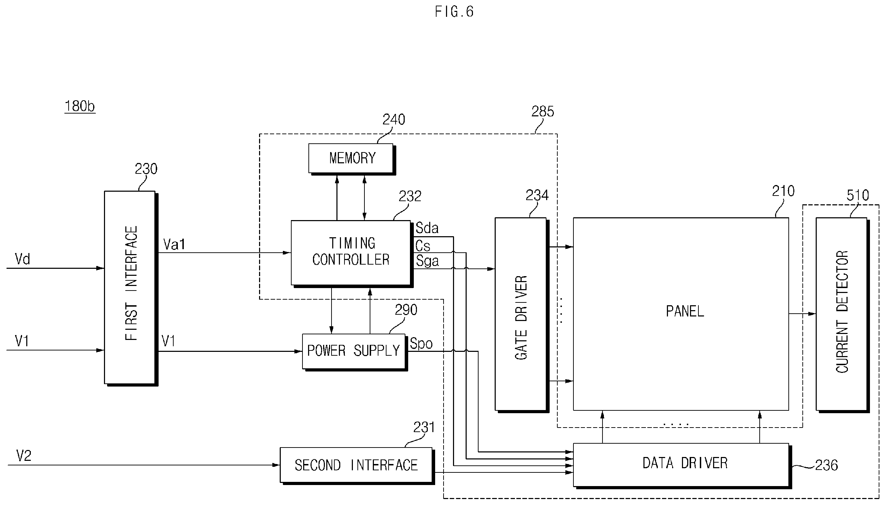

FIG. 6 is an internal block diagram of a second display of FIG. 3.

Referring to FIG. 6, the second display 180b based on an organic light emitting diode panel can include an organic light emitting diode (OLED) panel 210, a first interface 230, a second interface 231, a timing controller 232, a gate driver 234, a data driver 236, a memory 240, a power supply 290, a current detector 510, and the like.

The second display 180b can receive a video signal Vd, a first DC power V1, and a second DC power V2, and can display a predetermined image based on the video signal Vd.

Meanwhile, the first interface 230 in the second display 180b can receive the video signal Vd and the first DC power V1 from the signal processing device 170.

Here, the first DC power V1 can be used for the operation of the power supply 290 and the timing controller 232 in the second display 180b.

The second interface 231 can receive the second DC power V2 from an external power supply 190. Meanwhile, the second DC power V2 can be input to the data driver 236 in the second display 180b.

The timing controller 232 can output a data driving signal Sda and a gate driving signal Sga, based on the video signal Vd.

For example, when the first interface 230 converts the input video signal Vd and outputs a converted video signal va1, the timing controller 232 can output the data driving signal Sda and the gate driving signal Sga based on the converted video signal va1.

In addition to the video signal Vd from the signal processing device 170, the timing controller 232 can further receive a control signal, a vertical synchronization signal Vsync, and the like.

In addition to the video signal Vd, based on the control signal, the vertical synchronization signal Vsync, and the like, the timing controller 232 can output a gate driving signal Sga for the operation of the gate driver 234 and a data driving signal Sda for the operation of the data driver 236.

In this case, when the OLED panel 210 includes RGB subpixels, the data driving signal Sda can be a data driving signal for driving the RGB subpixels.

When the OLED panel 210 includes RGBW subpixels, the data driving signal Sda can be a data driving signal for driving the RGBW subpixels.

Meanwhile, the timing controller 232 can further output a control signal Cs to the gate driver 234.

The gate driver 234 and the data driver 236 supply a scan signal and a data signal to the OLED panel 210 through a gate line GL and a data line DL, respectively, according to the gate driving signal Sga and the data driving signal Sda from the timing controller 232. This allows the OLED panel 210 to display a predetermined image.

Meanwhile, the OLED panel 210 can include an organic light emitting layer. In order to display an image, a plurality of gate lines GL and data lines DL can be disposed in a matrix form in each pixel corresponding to the organic light emitting layer.

Meanwhile, as a scan signal is input to the gate line GL, the gate line GL can also be referred to as a scan line.

Meanwhile, the data driver 236 can output a data signal to the OLED panel 210 based on the second DC power V2 from the second interface 231.

The power supply 290 can supply various types of power to the gate driver 234, the data driver 236, the timing controller 232, and the like.

The current detector 510 can detect a current flowing through subpixels of the OLED panel 210. The detected current can be input to the processor 270 or the like, for a cumulative (or accumulated) current calculation.

Meanwhile, the timing controller 232, the gate driver 234, the data driver 236, and the memory 240 in the figure can be configured as a single integrated circuit (IC).

Therefore, the timing controller 232, the gate driver 234, the data driver 236, and the memory 240 can be collectively referred to as a driving controller 285.

Meanwhile, the driving controller 285 can include a buffer (not shown) to store frame data.

In particular, the timing controller 232 in the driving controller 285 can output a gate driving signal and a data driving signal based on the frame data stored in the buffer (not shown) or the memory 240.

The timing controller 232 or the driving controller 285 can perform various types of control in the second display 180b. For example, the driving controller 285 can control the gate driver 234, the data driver 236, the timing controller 232, and the like.

Meanwhile, the timing controller 232 or the driving controller 285 can receive current information flowing through subpixels of the OLED panel 210 from the current detector 510.

Then, based on the current information flowing through the subpixels of the OLED panel 210, the timing controller 232 or the driving controller 285 can calculate an accumulated current of each subpixel of the OLED panel 210. The calculated accumulated current can be stored in the memory 240.

Meanwhile, the timing controller 232 or the driving controller 285 can determine burn-in when the accumulated current of each subpixel of the OLED panel 210 is equal to or greater than an allowable value.

For example, when the accumulated current of each subpixel of the OLED panel 210 is equal to or greater than 300000 A, the timing controller 232 or the driving controller 285 can determine that a corresponding subpixel is a burn-in subpixel.

Meanwhile, when the accumulated current of a subpixel, among the subpixels of the OLED panel 210, is close to an allowable value, the timing controller 232 or the driving controller 285 can determine the corresponding subpixel as a burn-in predicted subpixel.

Meanwhile, based on the current detected by the current detector 510, the timing controller 232 or the driving controller 285 can determine a subpixel having the greatest accumulated current as a burn-in predicted subpixel.

Meanwhile, irrespective of the operation of the current detector 510, the timing controller 232 or the driving controller 285 can predict current information to flow through subpixels based on the video signal from the signal processing device 170, and can determine a burn-in predicted subpixel based on the predicted current information.

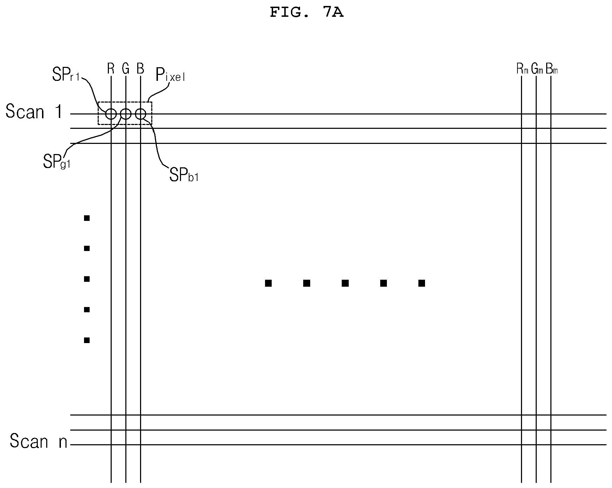

FIGS. 7A to 7D are diagrams referred to in the description of the OLED panel of FIG. 6.

FIG. 7A illustrates an example of a pixel in the OLED panel 210.

Referring to FIG. 7A, the OLED panel 210 can include a plurality of scan lines Scan 1 to Scan n and a plurality of data lines R1, G1, B1 to Rm, Gm, Bm intersecting the scan lines.

Meanwhile, a pixel (subpixel) is defined in an intersection area of the scan line and the data line in the OLED panel 210. In the figure, a pixel including RGB subpixels SR1, SG1, and SB1 is illustrated.

Meanwhile, the RGB subpixels SR1, SG1, and SB1 are respectively provided with a red organic light emitting diode, a green organic light emitting diode, and a blue organic light emitting diode.

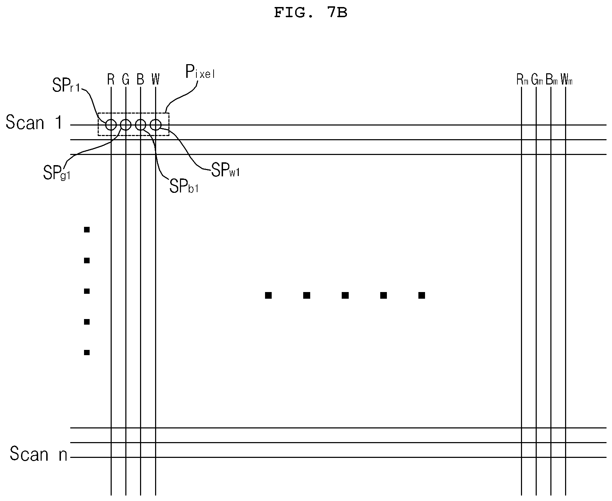

FIG. 7B illustrates another example of a pixel in the panel 210.

Referring to FIG. 7B, the panel 210 can include a plurality of scan lines Scan 1 to Scan n and a plurality of data lines R1, G1, B1, W1 to Rm, Gm, Bm, Wm intersecting the scan lines.

Meanwhile, a pixel (subpixel) is defined in an intersection area of the scan line and data line in the panel 210. In the figure, a pixel including RGBW subpixels SR1, SG1, SB1, and SW1 is illustrated.

The RGBW subpixels SR1, SG1, SB1, and SW1 are respectively provided with a red organic light emitting diode, a green organic light emitting diode, a blue organic light emitting diode, and a white organic light emitting diode.

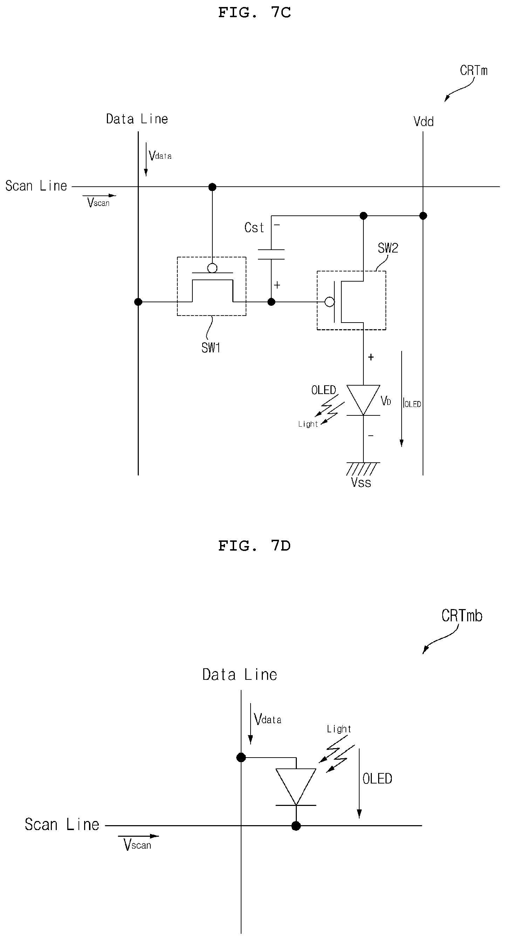

FIG. 7C illustrates an example of a circuit of a subpixel in the pixel of the panel of FIG. 7A or FIG. 7B.

Referring to FIG. 7C, a subpixel circuit CRTm, which is an active type, can include a scan switching element SW1, a storage capacitor Cst, a driving switching element SW2, and an organic light emitting layer OLED.

The scan switching element SW1 is connected at its gate terminal to a scan line and is turned on according to a scan signal Vdscan input thereto. When turned on, the scan switching element SW1 transfers the input data signal Vdata to the gate terminal of the driving switching element SW2 or one end of the storage capacitor Cst.

The storage capacitor Cst is provided between the gate terminal and the source terminal of the driving switching element SW2, and stores a predetermined difference between a data signal level transmitted to one end of the storage capacitor Cst and a DC voltage (VDD) level transmitted to the other end of the storage capacitor Cst.

For example, when the data signal has different levels according to a pulse amplitude modulation (PAM) scheme, the power level stored in the storage capacitor Cst varies according to the level difference of the data signal Vdata.

In another example, when the data signal has different pulse widths according to a pulse width modulation (PWM) scheme, the power level stored in the storage capacitor Cst varies according to the pulse width difference of the data signal Vdata.

The driving switching element SW2 is turned on according to the power level store in the storage capacitor Cst. When the driving switching element SW2 is turned on, a driving current IOLED proportional to the stored power level flows to the organic light emitting layer OLED. Accordingly, the organic light emitting layer OLED performs a light emitting operation.

The organic light emitting layer OLED includes a light emitting layer (EML) corresponding to a subpixel, and can include at least one of a hole injection layer (HIL), a hole transport layer (HTL), an electron transport layer (ETL), and an electron injection layer (EIL). In addition, the organic light emitting layer OLED can include a hole blocking layer and the like.

In the figure, although p-type MOSFETs are illustrated as the scan switching element SW1 and the driving switching element SW2, n-type MOSFETs or other switching elements such as JFET, IGBT, or SIC can also be used.

Meanwhile, the pixel is a hold-type element that continuously emits light in the organic light emitting layer OLED during a unit display period, specifically during a unit frame, after a scan signal is applied.

Meanwhile, the subpixel circuit CRTm in the figure is driven by an active-matrix scheme.

FIG. 7D illustrates another example of a circuit of a subpixel in the pixel of the panel of FIG. 7A or FIG. 7B.

Referring to FIG. 7D, an organic light emitting subpixel circuit CRTm, which is a passive type, can include only an organic light emitting diode LED without any separate switching element.

As illustrated in FIG. 7D, an anode of the organic light emitting diode LED can be connected to a data line so that a data signal Vdata is applied thereto, and a cathode of the organic light emitting diode LED can be connected to a scan line so that a scan signal Vscan is applied thereto.

The organic light emitting diode can emit light or remain non-emissive based on a plurality of subframes according to a passive-matrix scheme.

Meanwhile, unlike FIG. 7D, the anode of the organic light emitting diode LED can be connected to the scan line so that a scan signal Vscan is applied thereto, and the cathode of the organic light emitting diode LED can be connected to the data line so that a data signal Vdata is applied thereto.

Meanwhile, the subpixel circuit CRTm in the figure is driven by a passive-matrix scheme.

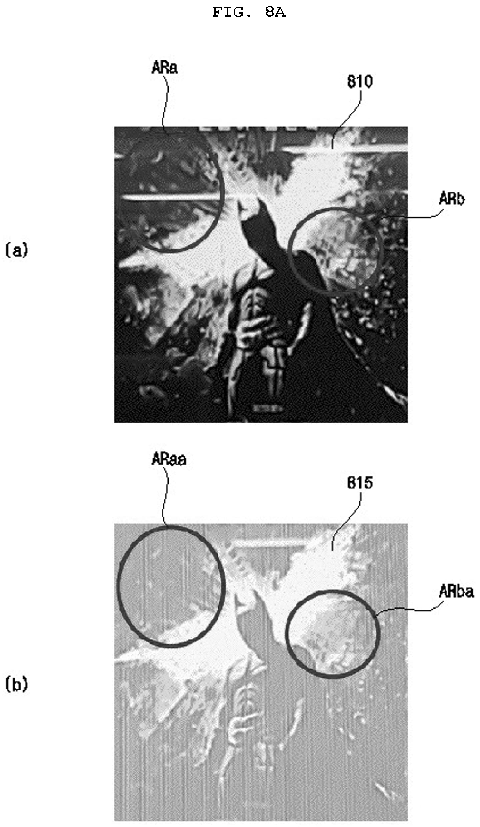

FIGS. 8A to 8C are diagrams for explaining the operation of a display apparatus for a vehicle related to the present disclosure.

FIG. 8A illustrates an example of an input image and a displayed image affected by external illuminance.

Referring to FIG. 8A, an input image 810 of (a) of FIG. 8A can include a low gray level area ARa having a luminance level lower than a reference level, and a chroma area Arb centered on chroma.

Meanwhile, as a level of external illuminance increases, as shown in (b) of FIG. 8A, a luminance level of a low gray level area Araa of a displayed image 815 decreases, making it difficult to distinguish the low gray level area, and a chroma level in a chroma area Arba decreases, making it difficult to distinguish chroma.

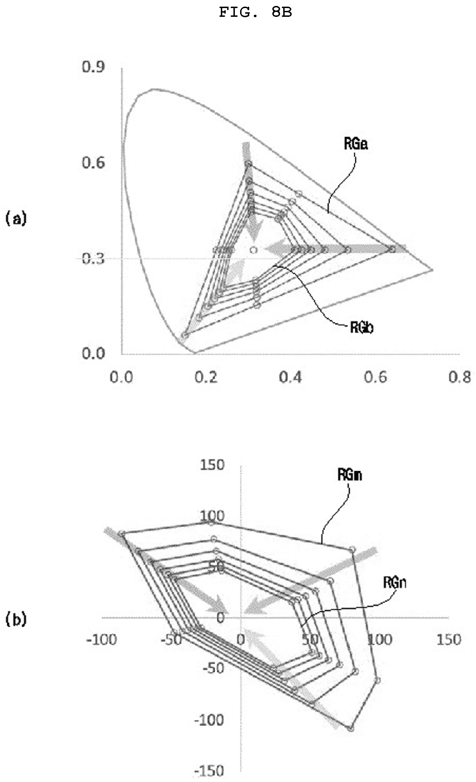

FIG. 8B illustrates a change in a color space according to external illuminance.

Referring to FIG. 8B, (a) of FIG. 8B illustrates a CIE-based color space.

As the level of external illuminance increases, the color space is reduced from a largest range RGa toward a smallest range RGb. Accordingly, as the level of external illuminance increases, color reproduction capability is reduced.

Referring to FIG. 8B, (b) of FIG. 8B illustrates a CIELAB-based color space.

As the level of external illuminance increases, the color space is reduced from a largest range RGm toward a smallest range RGn. Accordingly, as the level of external illuminance increases, color reproduction capability is reduced.

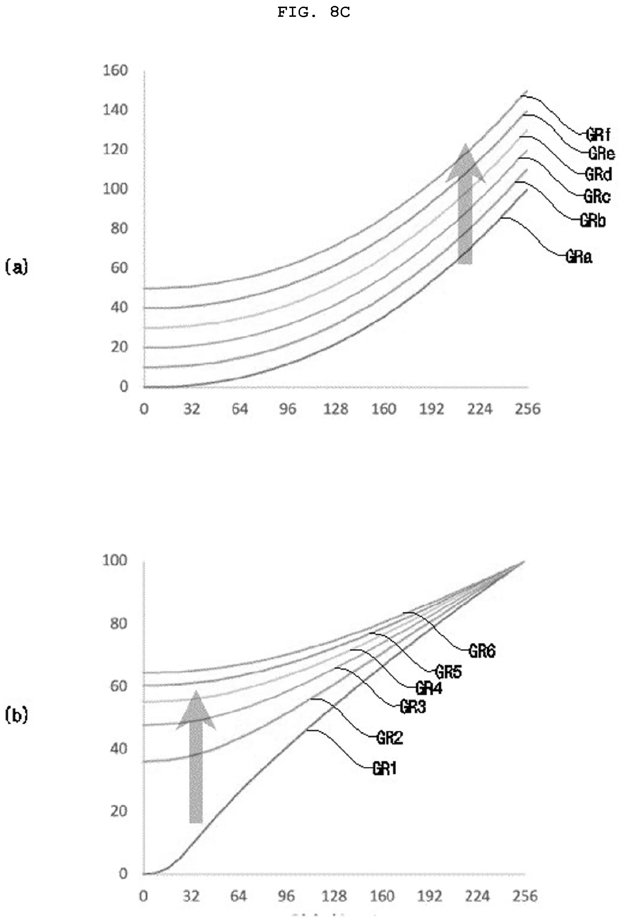

FIG. 8C illustrates a change in a luminance level according to external illuminance.

Referring to FIG. 8C, (a) of FIG. 8C illustrates various examples of a luminance conversion graph of output luminance with respect to input luminance according to a change in external illuminance.

As the level of external illuminance increases, the luminance conversion graph shifts from a graph GRa having a largest luminance range toward a graph GRf having a smallest luminance range, and accordingly, luminance level conversion can be perceived as being performed. Therefore, as the level of external illuminance increases, luminance reproduction capability is reduced.

Referring to FIG. 8C, (b) of FIG. 8C illustrates various examples of a CIELAB-based luminance conversion graph according to a change in external illuminance.

As the level of external illuminance increases, the luminance conversion graph shifts from a graph GR1 having a largest luminance range toward a graph GR6 having a smallest luminance range, and accordingly, luminance level conversion can be perceived as being performed. Therefore, as the level of external illuminance increases, luminance reproduction capability is reduced.

Accordingly, the present disclosure proposes a method for preventing a degradation of visibility based on ambient light. In particular, the present disclosure proposes a method for reducing degradation in perception of luminance and chroma based on ambient light.

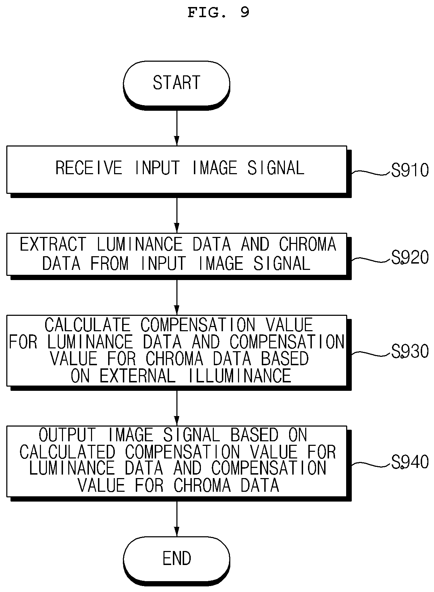

FIG. 9 is a flowchart illustrating a method of operating a display apparatus for a vehicle according to an embodiment of the present disclosure.

Referring to FIG. 9, the signal processing device 170 in the vehicle display apparatus 100 according to an embodiment of the present disclosure receives an input image signal (S910).

The input image signal can be an image signal received from a server 900, an image signal received from the mobile terminal 800, a camera image signal received from the camera 195, an image signal stored in the memory 140, etc.

Next, the signal processing device 170 according to an embodiment of the present disclosure extracts luminance data and chroma data from the input image signal (S920).

For example, when a format of the input image signal is an RGB format, the signal processing device 170 can convert the input image signal into a YCbCr format, extract a Y component from the image signal in the YCbCr format to obtain the luminance data, and extract Cb and Cr components to obtain the chroma data.

Next, the signal processing device 170 calculates a compensation value for the luminance data and a compensation value for the chroma data based on external illuminance information of a vehicle (S930).

For example, the signal processing device 170 can receive the external illuminance information of the vehicle from the external illuminance sensor 711 configured to sense external illuminance information of the vehicle.

Next, the signal processing device 170 outputs an output image signal based on the calculated compensation value for the luminance data and the calculated compensation value for the chroma data (S940).

Accordingly, it is possible to prevent degradation of visibility based on ambient light. In particular, it is possible to reduce degradation in perception of luminance and chroma based on ambient light.

Meanwhile, in step S930, the signal processing device 170 can calculate the compensation value for the luminance data based on an average value of the luminance data of the input image signal, and calculate the compensation value for the chroma data based on a standard deviation of the chroma data of the input image signal. Accordingly, it is possible to prevent degradation of visibility based on ambient light.

In this case, the average value of the luminance data of the input image signal, which is an average value of luminance data for each frame, can be an average picture level (APL).

Meanwhile, the signal processing device 170 can be configured to increase the compensation value for the luminance data and the compensation value for the chroma data as a level of the external illuminance information of the vehicle increases. Accordingly, it is possible to prevent degradation of visibility even when the level of the external illuminance information increases.

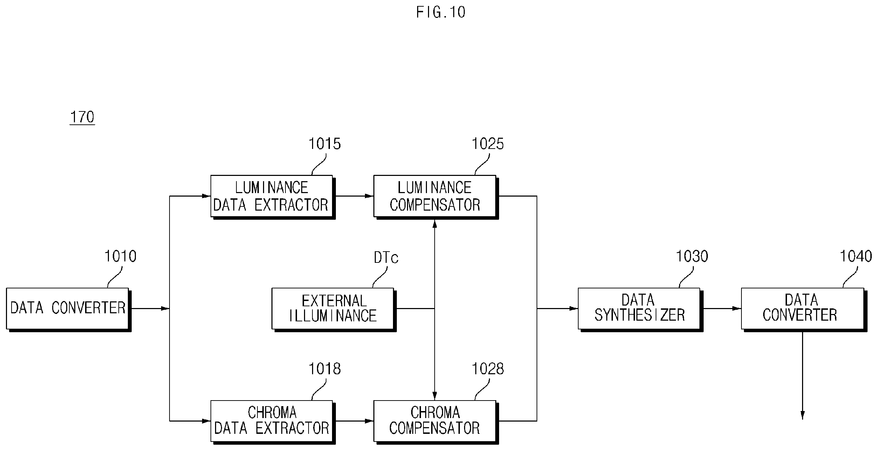

FIG. 10 illustrates an example of an internal block diagram of a signal processing device (170) according to an embodiment of the present disclosure.

Referring to FIG. 10, the signal processing device 170 according to an embodiment of the present disclosure can include a data converter 1010, a luminance data extractor 1015, a chroma data extractor 1018, a luminance compensator 1025, a chroma compensator 1028, a data synthesizer 1030, and a data converter 1040.

First, when a format of an input image signal is an RGB format, the data converter 1010 in the signal processing device 170 can convert the input image signal into a YCbCr format.

Meanwhile, when the format of the input image signal is a YCbCr format, the data converter 1010 in the signal processing device 170 can bypass the input image signal without data conversion.

Next, the luminance data extractor 1015 in the signal processing device 170 can extract a Y component from the image signal in the YCbCr format from the data converter 1010 to obtain luminance data.

Meanwhile, the chroma data extractor 1018 in the signal processing device 170 can extract Cb and Cr components from the image signal in the YCbCr format from the data converter 1010 to obtain chroma data.

Next, the luminance compensator 1025 in the signal processing device 170 can calculate a compensation value for the extracted luminance data based on an external illuminance level DTc.

For example, the luminance compensator 1025 in the signal processing device 170 can calculate the compensation value for the luminance data based on an average value of the luminance data of the input image signal.

Meanwhile, the luminance compensator 1025 in the signal processing device 170 can calculate the compensation value for the luminance data based on the external illuminance level DTc relative to a maximum displayable luminance of a display.

For example, the luminance compensator 1025 in the signal processing device 170 can be configured to decrease the compensation value for the luminance data as a level of the maximum displayable luminance of the display increases.

Meanwhile, the luminance compensator 1025 in the signal processing device 170 can be configured to increase the compensation value for the luminance data as a level of external illuminance information of the vehicle increases.

In addition, the luminance compensator 1025 in the signal processing device 170 can output compensated luminance data obtained by adding the compensation value for the luminance data to the luminance data.

Next, the chroma compensator 1028 in the signal processing device 170 can calculate a compensation value for the extracted chroma data based on the external illuminance level DTc.

For example, the chroma compensator 1028 in the signal processing device 170 can calculate the compensation value for the chroma data based on a standard deviation of the chroma data of the input image signal.

Meanwhile, the chroma compensator 1028 in the signal processing device 170 can calculate the compensation value for the chroma data based on the external illuminance level DTc relative to the maximum displayable luminance of the display.

For example, the chroma compensator 1028 in the signal processing device 170 can be configured to decrease the compensation value for the chroma data as the level of the maximum displayable luminance of the display increases.

Meanwhile, the chroma compensator 1028 in the signal processing device 170 can be configured to increase the compensation value for the chroma data as the level of the external illuminance information of the vehicle increases.

In addition, the chroma compensator 1028 in the signal processing device 170 can output compensated chroma data obtained by adding the compensation value for the chroma data to the chroma data.

Meanwhile, the data synthesizer 1030 in the signal processing device 170 can synthesize the compensated luminance data and the compensated chroma data.

Next, the data converter 1040 in the signal processing device 170 can convert the image signal in the YCbCr format from the data synthesizer 1030 into an image signal in an RGB format to output an output image signal.

Accordingly, it is possible to prevent degradation of visibility based on ambient light. In particular, it is possible to reduce degradation in perception of luminance and chroma based on ambient light.

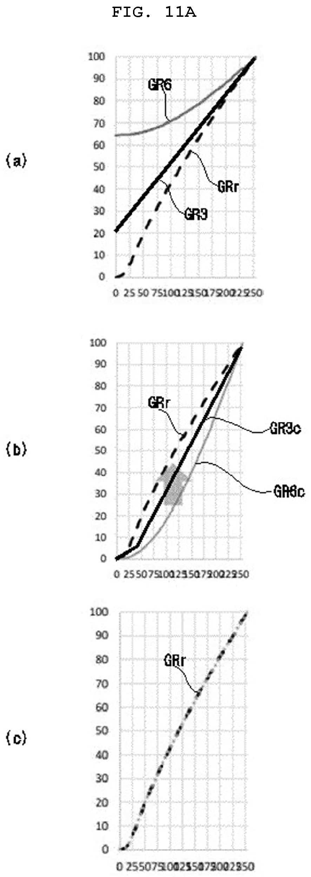

FIGS. 11A to 12B are diagrams referred to in the description of FIG. 9 or FIG. 10.

FIG. 11A illustrates an example of luminance compensation based on external illuminance.

Referring to FIG. 11A, the signal processing device 170 can perform luminance conversion on a luminance level of an input image signal based on a reference conversion graph GRr to output an output image signal having a converted luminance level.

Meanwhile, as a level of external illuminance increases, luminance conversion perceived by a user, such as a driver, shifts from a graph GR1 toward a graph GR6, as shown in (b) of FIG. 8C, and can be perceived as luminance level conversion being performed. Accordingly, as the level of external illuminance increases, luminance reproduction capability is reduced.

(a) of FIG. 11A illustrates, among the graphs GR1 to GR6 of (b) of FIG. 8C, a graph GR6 corresponding to a highest level of external illuminance and a graph GR3 corresponding to a lower level of external illuminance than the graph GR6.

Next, (b) of FIG. 11A illustrates luminance compensation graphs corresponding to the graph GR3 and the graph GR6 of (a) of FIG. 11A.

The signal processing device 170 according to an embodiment of the present disclosure can be configured to increase a compensation value for luminance data as the level of external illuminance increases.

For example, when the external illuminance level corresponds to the graph GR6, the signal processing device 170 can cause luminance conversion to be performed based on a graph GR6c corresponding to the graph GR6 and having a largest compensation value for the luminance data.

Meanwhile, the graph GR6c can have a lower output luminance level with respect to input luminance than the reference graph GRr, but a rate of change of output luminance with respect to input luminance, i.e., an instantaneous slope, is preferably greater.

Meanwhile, when the external illuminance level corresponds to the graph GR3, the signal processing device 170 can cause luminance conversion to be performed based on a graph GR3c for compensating the luminance data.

In this case, the graph GR3c can have a lower output luminance level with respect to input luminance than the reference graph GRr, but a rate of change of output luminance with respect to input luminance, i.e., an instantaneous slope, is preferably greater.

Meanwhile, the graph GR3c can have a higher output luminance level with respect to input luminance than the graph GR6c, but a rate of change of output luminance with respect to input luminance, i.e., an instantaneous slope, is preferably greater.

Thus, the signal processing device 170 can be configured to perform luminance conversion based on a luminance compensation value according to the level of external illuminance so that the luminance conversion corresponds to the reference graph GRr, as shown in (c) of FIG. 11A. Accordingly, it is possible to prevent degradation of visibility even when the external illuminance level of the vehicle varies.

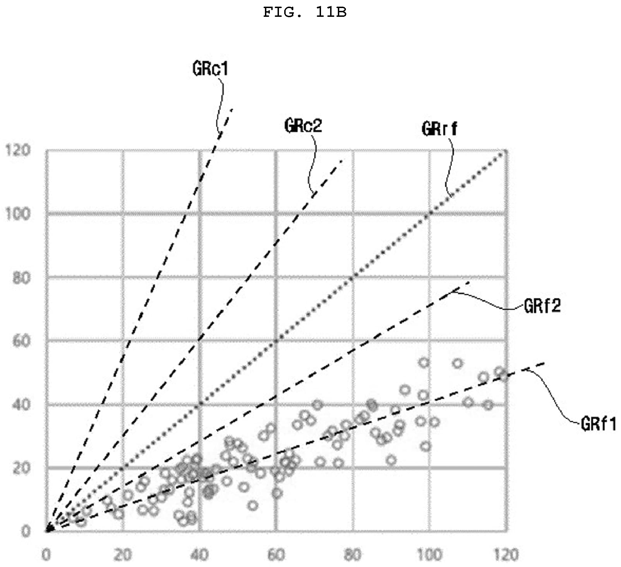

FIG. 11B illustrates an example of chroma compensation based on external illuminance.

Referring to FIG. 11B, the signal processing device 170 can perform chroma conversion on a chroma level of an input image signal based on a reference conversion graph GRrf to output an output image signal having a converted chroma level.

Meanwhile, as a level of external illuminance increases, chroma conversion perceived by a user, such as a driver, shifts from the graph GRrf toward a graph GRf1, and can be perceived as chroma level conversion being performed. Accordingly, as the level of external illuminance increases, chroma reproduction capability is reduced.

In particular, FIG. 11B illustrates a graph GRf1 corresponding to a highest level of external illuminance and a graph GRf2 corresponding to a lower level of external illuminance than the graph GRf1.

Meanwhile, the signal processing device 170 according to an embodiment of the present disclosure can be configured to increase a compensation value for chroma data as the level of external illuminance increases.

For example, when the external illuminance level corresponds to the graph GRf1, the signal processing device 170 can cause chroma conversion to be performed based on a graph GRc1 corresponding to the graph GRf1 and having a largest compensation value for the chroma data.

Meanwhile, the graph GRc1 preferably has a higher output chroma level with respect to input chroma than the reference graph GRrf.

Meanwhile, when the external illuminance level corresponds to the graph GRf2 graph, the signal processing device 170 can cause chroma conversion to be performed based on a graph GRc2 for compensating the chroma data.

In this case, the graph GRc2 can have a higher output chroma level with respect to input chroma than the reference graph GRrf.

Meanwhile, the graph GRc2 preferably has a lower output chroma level with respect to input chroma than the graph GRc1.

Thus, the signal processing device 170 can be configured to perform chroma conversion based on a chroma compensation value according to the level of external illuminance so that chroma conversion corresponds to the reference graph GRrf, as shown in (c) of FIG. 11B. Accordingly, it is possible to prevent degradation of visibility even when the external illuminance level of the vehicle varies.

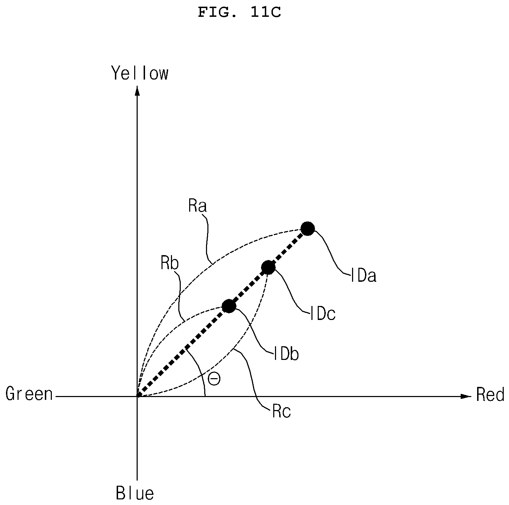

FIG. 11C illustrates an example of chroma compensation based on external illuminance.

Referring to FIG. 11C, a chroma area can be divided into a red-green region along a horizontal axis, and a yellow-blue region along a vertical axis.

Meanwhile, first chroma data IDa includes a red component and a yellow component, a ratio of the yellow component to the red component is θ, and a level corresponding to a magnitude thereof can be defined as Ra.

Meanwhile, when an external illuminance level is a first level, the first chroma data IDa can be perceived as second chroma data IDb.

In this case, the second chroma data IDb includes a red component and a yellow component, a ratio of the yellow component to the red component is θ, and a level corresponding to a magnitude thereof can be defined as Rb, which is smaller than Ra. Accordingly, visibility is degraded based on ambient light.

In order to prevent such degradation of visibility, since a standard deviation of chroma data of an input image signal can be more accurate than an average value of the chroma data as a compensation value for the chroma data, the signal processing device 170 according to an embodiment of the present disclosure can calculate the compensation value for the chroma data based on the standard deviation of the chroma data of the input image signal.

That is, the compensation value for the chroma data can be calculated based on the standard deviation of the chroma data of the input image signal. Accordingly, it is possible to prevent degradation of visibility based on ambient light.

That is, in order to prevent the first chroma data IDa from being perceived as the second chroma data IDb, the signal processing device 170 can calculate a compensation value for the chroma data corresponding to Ra-Rb and compensate the chroma data based on the calculated compensation value.

Accordingly, the first chroma data IDa can be perceived as the first chroma data IDa despite ambient light.

Meanwhile, when the level of external illuminance is lower than the first level, the first chroma data IDa can be perceived as third chroma data IDc.

In this case, the third chroma data IDc includes a red component and a yellow component, a ratio of the yellow component to the red component is θ, and a level corresponding to a magnitude thereof can be defined as Rc, which is smaller than Ra and greater than Rb. Accordingly, visibility is degraded based on ambient light.

Meanwhile, in order to prevent the first chroma data IDa from being perceived as the third chroma data IDc, the signal processing device 170 according to an embodiment of the present disclosure can calculate a compensation value for the chroma data corresponding to Ra-Rc and compensate the chroma data based on the calculated compensation value. In this case, the chroma compensation value Ra-Rc is preferably smaller than Ra-Rb.

Accordingly, the first chroma data IDa can be perceived as the first chroma data IDa despite ambient light.

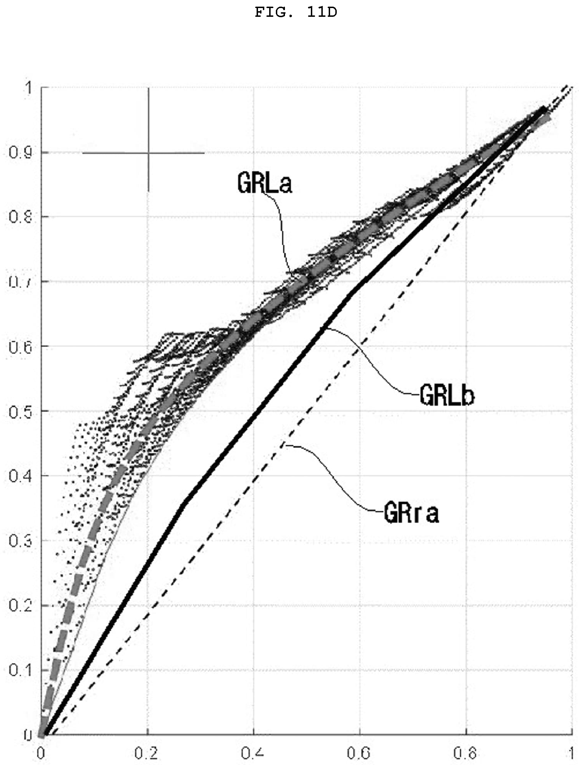

FIG. 11D illustrates an example of a compensated luminance graph based on external illuminance.

Referring to FIG. 11D, luminance conversion of an input image signal can be performed based on a reference graph GRra.

That is, the signal processing device 170 can convert a luminance level of the input image signal on a horizontal axis into a luminance level of an output image signal on a vertical axis.

Meanwhile, in response to an external illuminance level being a first level, the signal processing device 170 according to an embodiment of the present disclosure can be configured to calculate a compensation value corresponding to the first level, and perform luminance conversion based on a first luminance conversion graph GRLa including the compensation value. Accordingly, it is possible to prevent degradation of visibility based on ambient light.

Meanwhile, compared to the reference graph GRra, the first luminance conversion graph GRLa preferably has a higher luminance level of the output image signal.

Meanwhile, when the external illuminance level is a second level lower than the first level, the signal processing device 170 according to an embodiment of the present disclosure can be configured to calculate a compensation value corresponding to the second level, and perform luminance conversion based on a second luminance conversion graph GRLb including the compensation value. Accordingly, it is possible to prevent degradation of visibility based on ambient light.

Meanwhile, compared to the reference graph GRra, the first luminance conversion graph GRLa preferably has a higher output luminance level of the output image signal.

Meanwhile, compared to the first luminance conversion graph GRLa, the second luminance conversion graph GRLb preferably has a lower output luminance level of the output image signal.

Meanwhile, while calculating the compensation value for the luminance data based on external illuminance information of the vehicle, in response to a first luminance level of the input image signal being less than a reference luminance level, the signal processing device 170 can increase the first luminance level by a first luminance increment, and in response to a second luminance level of the input image signal being greater than the reference luminance level, the signal processing device 170 can increase the second luminance level by a second increment less than the first luminance increment. Accordingly, it is possible to prevent degradation of visibility based on ambient light.

As shown in the figure, according to the first luminance conversion graph GRLa, when the first luminance level of the input image signal is 0.2 on the horizontal axis, the reference luminance level is 0.4 on the horizontal axis, and the second luminance level is 0.6 on the horizontal axis, the first luminance level of the input image signal can be converted to approximately 0.45, and the second luminance level of the input image signal can be converted to approximately 0.75.

That is, according to the first luminance conversion graph GRLa, the first luminance increment of the first luminance level is approximately 0.25 (0.45 - 0.2), and the second luminance increase increment of the second luminance level is approximately 0.15 (0.75 - 0.6).

Therefore, the first luminance increment is greater than the second luminance increment. Accordingly, it is possible to prevent degradation of visibility based on ambient light. In particular, it is possible to prevent degradation of visibility in a low gray level area based on ambient light.

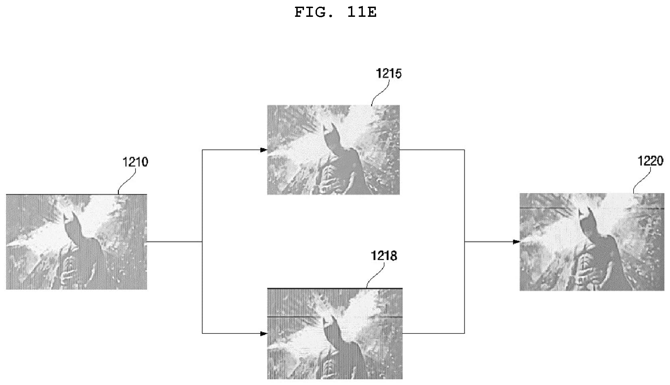

FIG. 11E illustrates an example of an output of a compensated image compared to an input image.

Referring to FIG. 11E, the signal processing device 170 according to an embodiment of the present disclosure receives an input image 1210 and separates luminance data and chroma data included in the input image 1210.

Next, the signal processing device 170 can calculate a compensation value for the luminance data based on an external illuminance level, and can generate a compensated luminance-based image 1215 based on the compensation value for the luminance data.

Next, the signal processing device 170 can calculate a compensation value for the chroma data based on the external illuminance level, and can generate a compensated chroma-based image 1218 based on the compensation value for the chroma data.

Next, the signal processing device 170 can combine the compensated luminance-based image 1215 and the compensated chroma-based image 1218 to output a compensated image 1220. Accordingly, it is possible to output an image in which luminance and chroma are compensated based on external illuminance, thereby preventing a degradation of visibility based on ambient light.

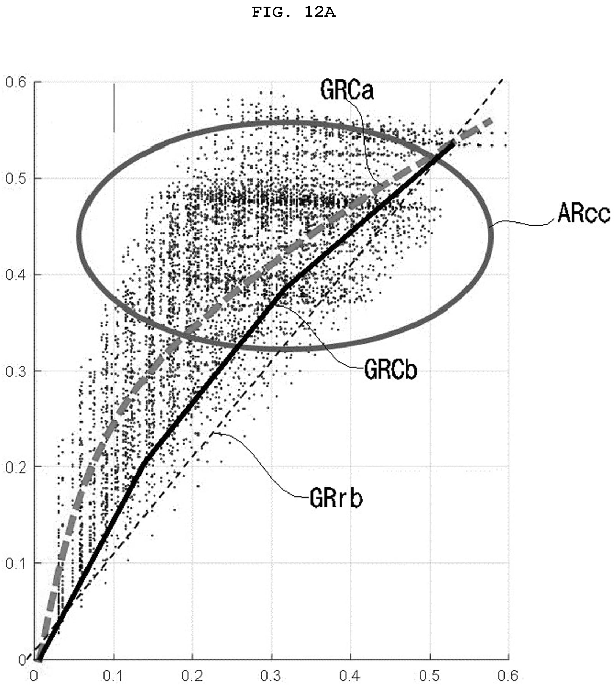

FIG. 12A illustrates an example of a compensated chroma graph based on external illuminance.

Referring to FIG. 12A, chroma conversion of an input image signal can be performed based on a reference graph GRrb.

That is, the signal processing device 170 can convert a chroma level of the input image signal on a horizontal axis into a chroma level of an output image signal on a vertical axis.

Meanwhile, in response to an external illuminance level being a first level, the signal processing device 170 according to an embodiment of the present disclosure can be configured to calculate a compensation value corresponding to the first level, and perform chroma conversion based on a first chroma conversion graph GRCa including the compensation value. Accordingly, it is possible to prevent degradation of visibility based on ambient light.

Meanwhile, compared to the reference graph GRrb, the first chroma conversion graph GRCa preferably has a higher chroma level of the output image signal.

Accordingly, chroma compensation can be efficiently performed in a high-chroma area ARcc above a reference chroma level.

Meanwhile, when the external illuminance level is a second level lower than the first level, the signal processing device 170 according to an embodiment of the present disclosure can be configured to calculate a compensation value corresponding to the second level, and perform chroma conversion based on a second chroma conversion graph GRCb including the compensation value. Accordingly, it is possible to prevent degradation of visibility based on ambient light.

Meanwhile, compared to the reference graph GRrb, the first chroma conversion graph GRCa preferably has a higher chroma level of the output image signal.

Meanwhile, compared to the first chroma conversion graph GRCa, the second chroma conversion graph GRCb preferably has a lower chroma level of the output image signal.

Meanwhile, while calculating a compensation value for chroma data based on external illuminance information of the vehicle, in response to a first chroma level being less than a reference chroma level, the signal processing device 170 can increase the first chroma level of the input image signal by a first chroma increment, and in response to a second chroma level being greater than the reference chroma level, the signal processing device 170 can increase the first chroma level of the input image signal by a second chroma increment less than the first chroma increment. Accordingly, it is possible to prevent degradation of visibility based on ambient light.

As shown in the figure, according to the first chroma conversion graph GRCa, when the first chroma level of the input image signal is 0.2 on the horizontal axis, the reference chroma level is 0.3 on the horizontal axis, and the second chroma level is 0.4 on the horizontal axis, the first chroma level of the input image signal can be converted to approximately 0.35, and the second chroma level of the input image signal can be converted to approximately 0.48.

That is, according to the first chroma conversion graph GRLa, the first chroma increment of the first chroma level is approximately 0.15 (0.35 - 0.2), and the second chroma increment of the second chroma level is approximately 0.08 (0.48 - 0.4).

Therefore, the first chroma increment is greater than the second chroma increment. Accordingly, it is possible to prevent degradation of visibility based on ambient light. In particular, it is possible to prevent degradation of visibility in a low chroma area based on ambient light.

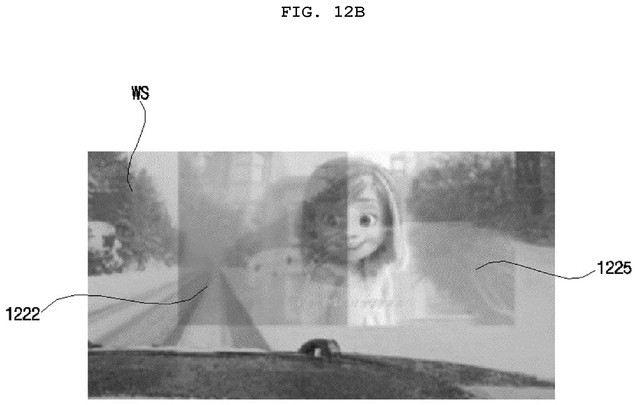

FIG. 12B illustrates an example of an image projected onto a windshield.

Referring to FIG. 12B, the image output device 180t according to an embodiment of the present disclosure can output a first image 1222 onto a windshield WS without compensation for external illuminance.

Meanwhile, the image output device 180t according to an embodiment of the present disclosure can output a second image 1225, in which luminance and chroma are compensated based on external illuminance, onto the windshield WS.

When the first image 1222 and the second image 1225 are compared, the second image 1225 exhibits an increased luminance level and an increased chroma level, thereby improving sharpness and the like. Accordingly, it is possible to prevent degradation of visibility based on ambient light.

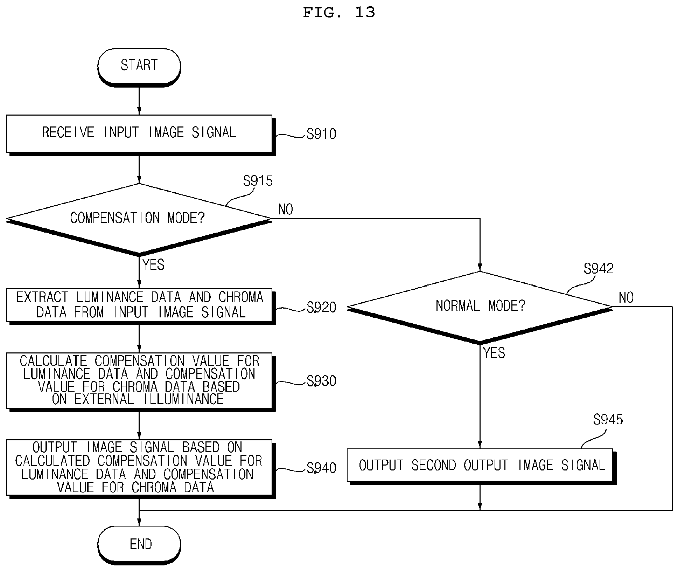

FIG. 13 is a flowchart illustrating a method of operating a display apparatus for a vehicle according to another embodiment of the present disclosure.

Referring to FIG. 13, the signal processing device 170 in the vehicle display device 100 according to another embodiment of the present disclosure receives an input image signal (S910).

Next, the signal processing device 170 according to an embodiment of the present disclosure determines whether a compensation mode for compensating external illuminance is to be applied (S915), and executes the compensation mode when the compensation mode is determined to be applied.

That is, according to the compensation mode, the signal processing device 170 extracts luminance data and chroma data from the input image signal (S920).

For example, when a format of the input image signal is an RGB format, the signal processing device 170 can convert the input image signal into a YCbCr format, extract a Y component from the image signal in the YCbCr format to obtain the luminance data, and extract Cb and Cr components to obtain the chroma data.

Next, the signal processing device 170 calculates a compensation value for the luminance data and a compensation value for the chroma data based on external illuminance information of a vehicle (S930).

For example, the signal processing device 170 can receive the external illuminance information of the vehicle from the external illuminance sensor 711 configured to sense external illuminance information of the vehicle.

Next, the signal processing device 170 outputs an output image signal based on the calculated compensation value for the luminance data and the calculated compensation value for the chroma data (S940).

Accordingly, it is possible to prevent degradation of visibility based on ambient light. In particular, it is possible to reduce degradation in perception of luminance and chroma based on ambient light.

Meanwhile, in step S930, the signal processing device 170 can calculate the compensation value for the luminance data based on an average value of the luminance data of the input image signal, and calculate the compensation value for the chroma data based on a standard deviation of the chroma data of the input image signal. Accordingly, it is possible to prevent degradation of visibility based on ambient light.

In this case, the average value of the luminance data of the input image signal, which is an average value of luminance data for each frame, can be an average picture level (APL).

Meanwhile, the signal processing device 170 can be configured to increase the compensation value for the luminance data and the compensation value for the chroma data as a level of the external illuminance information of the vehicle increases. Accordingly, it is possible to prevent degradation of visibility even when the level of external illuminance information increases.

Meanwhile, when the compensation mode is not applied in step S915, the signal processing device 170 determines whether a normal mode is to be applied (S942), and when the normal mode is determined to be applied, the signal processing device 170 performs luminance conversion corresponding to the normal mode and outputs a second output image signal subjected to the luminance conversion (S945). Accordingly, an image based on the normal mode can be displayed.

Meanwhile, the signal processing device 170 can be configured to execute the compensation mode in response to the external illuminance information of the vehicle being greater than or equal to a reference level, and execute the normal mode in response to the external illuminance information of the vehicle being less than the reference level.

Meanwhile, the signal processing device 170 can be configured to execute the compensation mode in a daytime driving mode, and execute the normal mode in a nighttime driving mode.

Meanwhile, the signal processing device 170 can be configured to execute the normal mode when the vehicle enters a tunnel while executing the compensation mode.

Meanwhile, the signal processing device 170 can be configured to execute the compensation mode when the vehicle exits the tunnel while executing the normal mode in the tunnel.

In this case, the signal processing device 170 can be configured to apply an intensity (or level) of the compensation mode in a stepwise manner.

For example, the signal processing device 170 can cause the compensation mode to be a first intensity when the vehicle has exited the tunnel at a first time point, and cause the compensation mode to be a second intensity greater than the first intensity at a second time point subsequent to the first time after the vehicle exits the tunnel. Accordingly, degradation of visibility can be gradually prevented by the stepwise compensation mode.

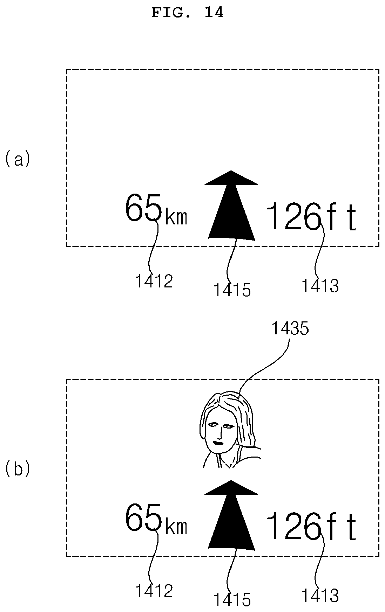

Meanwhile, the signal processing device 170 can be configured to output a first image including text in the normal mode, and output a second image including an object or an image in the compensation mode based on external illuminance information of the vehicle. This will be described with reference to FIG. 14.

FIG. 14 is a diagram referred to in the description of FIG. 13.

Referring to FIG. 14, in a normal mode, the signal processing device 170 can be configured to output a first image 1410 including text, as shown in (a) of FIG. 14.

For example, the first image 1410 can include speed information 1412 and distance information 1413 as text.

Meanwhile, the first image 1410 can further include a symbol or graphic indicating traveling direction information 1415.

In a compensation mode, the signal processing device 170 can be configured to output a second image 1420 including an object or an image, as shown in (b) of FIG. 14.

For example, the second image 1420 can include an object or image 1435.

Meanwhile, the second image 1420 can further include text in addition to the object or image 1435.

That is, the second image 1420 can further include speed information 1412 and distance information 1413 as text, in addition to the object or image 1435.

Meanwhile, the second image 1420 can further include a symbol or graphic indicating traveling direction information 1415.

Thus, the signal processing device 170 can be configured to display more information or data in the compensation mode than in the normal mode. Accordingly, it is possible to provide various information while preventing degradation of visibility based on ambient light.

Meanwhile, in response to switching from the normal mode to the compensation mode, the signal processing device 170 can be configured to switch an output from the first image 1410 including text to the second image 1420 including an image 1435 in addition to the text. Accordingly, it is possible to prevent degradation of visibility based on ambient light.

Meanwhile, in response to switching from the compensation mode to the normal mode, the signal processing device 170 can be configured to switch an output from the second image 1420 including an image 1435 to the first image 1410 including text. Accordingly, it is possible to prevent degradation of visibility based on ambient light.

Meanwhile, in the compensation mode, the signal processing device 170 can output the second image 1420 including an image 1435 to the image output device 180t.

For example, the image output device 180t can include a head-up display device 180h including a picture generation device 300 configured to output a projection image toward a windshield WS. Accordingly, it is possible to prevent degradation of visibility based on ambient light in the head-up display device 180h.

In another example, the image output device 180t can include a display 180b including an organic light emitting diode panel. Accordingly, it is possible to prevent degradation of visibility based on ambient light in the display 180b based on the organic light emitting diode panel.

In another example, the image output device 180t can include a display 180b including a transparent organic light emitting diode panel. In this case, transparency of the transparent organic light emitting diode panel can be lower than transparency of the windshield WS. Accordingly, it is possible to prevent degradation of visibility based on ambient light in the display 180b based on the transparent organic light emitting diode panel.

Meanwhile, in another embodiment of the present disclosure, the signal processing device 170 can be configured to output the first image 1410 in the normal mode, and output the second image 1420 having an increased luminance level and an increased chroma level than the first image 1420 in the compensation mode based on external illuminance information of the vehicle. Accordingly, it is possible to prevent degradation of visibility due to external illuminance.

It will be apparent that, although the preferred embodiments have been shown and described above, the present disclosure is not limited to the above-described specific embodiments, and various modifications and variations can be made by those skilled in the art without departing from the gist of the appended claims. Thus, it is intended that the modifications and variations should not be understood independently of the technical idea or prospect of the present disclosure.

## Claims

1. A display apparatus for a vehicle, the display apparatus comprising:
an illuminance sensor configured to sense external illuminance information of the vehicle;
an image output device configured to output an image; and
a signal processing device configured to output an output image signal to the image output device based on an input image signal,
wherein the signal processing device is configured to:
extract luminance data and chroma data from the input image signal;
calculate a compensation value for the luminance data and a compensation value for the chroma data based on the external illuminance information of the vehicle; and
output an output image signal based on the calculated compensation value for the luminance data and the calculated compensation value for the chroma data.

2. The display apparatus of claim 1, wherein the signal processing device is configured to:
calculate the compensation value for the luminance data based on an average value of the luminance data of the input image signal; and
calculate the compensation value for the chroma data based on a standard deviation of the chroma data of the input image signal.

3. The display apparatus of claim 1, wherein the signal processing device is configured to increase the compensation value for the luminance data and the compensation value for the chroma data as a level of the external illuminance information of the vehicle increases.

4. The display apparatus of claim 1, wherein, while calculating the compensation value for the luminance data based on the external illuminance information of the vehicle, the signal processing device is configured to:
in response to a first luminance level of the input image signal being less than a reference luminance level, increase the first luminance level by a first luminance increment; and
in response to a second luminance level of the input image signal being greater than the reference luminance level, increase the second luminance level by a second luminance increment less than the first luminance increment.

5. The display apparatus of claim 1, wherein, while calculating the compensation value for the chroma data based on the external illuminance information of the vehicle, the signal processing device is configured to:
in response to a first chroma level of the input image signal being less than a reference chroma level, increase the first chroma level by a first chroma increment; and
in response to a second chroma level of the input image signal being greater than the reference chroma level, increase the second chroma level by a second chroma increment less than the first chroma increment.

6. The display apparatus of claim 1, wherein the signal processing device is configured to:
output a first image including text in a normal mode; and
output a second image including an object or an image in a compensation mode based on the external luminance information of the vehicle.

7. The display apparatus of claim 1, wherein, in response to switching from a normal mode to a compensation mode, the signal processing device is configured to switch an output from a first image including text to a second image including an object or an image in addition to the text.

8. The display apparatus of claim 1, wherein the image output device comprises a picture generation device configured to output a projection image toward a windshield.

9. The display apparatus of claim 1, wherein the image output device comprises a display including an organic light emitting diode panel.

10. The display apparatus of claim 1, wherein the image output device comprises a display including a transparent organic light emitting diode panel, and
wherein a transparency of the transparent organic light emitting diode panel is lower than a transparency of a windshield.

11. A display apparatus for a vehicle, the display apparatus comprising:
an illuminance sensor configured to sense external illuminance information of the vehicle;
an image output device configured to output an image; and
a signal processing device configured to output an output image signal to the image output device based on an input image signal,
wherein the signal processing device is configured to:
output a first image in a normal mode; and
output a second image having an increased luminance level and an increased chroma level than the first image in a compensation mode based on the external illuminance information of the vehicle.

12. The display apparatus of claim 11, wherein the signal processing device is configured to:
output the first image including text in the normal mode; and
output a second image including an object or an image in the compensation mode based on the external illuminance information of the vehicle.

13. The display apparatus of claim 11, wherein, in response to switching from the normal mode to the compensation mode, the signal processing device is configured to switch an output from the first image including text to the second image including an object or an image in addition to the text.

14. The display apparatus of claim 11, wherein the image output device comprises a picture generation device configured to output a projection image toward a windshield.

15. The display apparatus of claim 11, wherein the image output device comprises a display including an organic light emitting diode panel.
